# EUROPEAN PATENT SPECIFICATION

(11) **EP 2 177 825 B1**
(45) Date of publication and mention of the grant of the patent: **19.10.2011**
(21) Application number: 09011025.5
(22) Date of filing: 27.08.2009
(51) Int. Cl.: F21V 29/00, F21V 19/00

(54) **Lighting apparatus having light emitting diodes for light source**
Beleuchtungsvorrichtung mit lichtemittierenden Dioden für eine Lichtquelle
Appareil d'éclairage doté de diodes électroluminescentes en tant que source lumineuse

(30) Priority: 28.08.2008 JP 2008219690
(43) Date of publication of application: 21.04.2010
(73) Proprietor: Toshiba Lighting & Technology Corporation, Yokosuka-shi Kanagawa 237-8510 (JP)
(72) Inventor: Higuchi, Kazunari, Yokosuka-shi Kanagawa 237-8510 (JP); Moriyama, Takayoshi, Yokosuka-shi Kanagawa 237-8510 (JP); Hashimoto, Sumio, Yokosuka-shi Kanagawa 237-8510 (JP); Kumashiro, Shinichi, Yokosuka-shi Kanagawa 237-8510 (JP)
(74) Representative: Kramer - Barske - Schmidtchen

(56) References cited:
- EP-A- 1 030 099
- EP-A- 1 767 967
- US-B1- 6 552 658

## Description

The present invention relates to a lighting apparatus that uses a light emitting element such as a light emitting diode (LED).

In recent years, a lighting apparatus has been developed which uses as a light source module which has a substrate arranged light emitting elements, such as an LED, disposed on a substrate. To produce a higher output from the lighting apparatus requires an increasing number of LEDs, etc., in the apparatus. This increases the substrate size. In such a type of lighting apparatus, the substrate is fixed to the apparatus body by means of screws attached to more than one part of the substrate, when the substrate is mounted on the apparatus. Light emitting elements generate heat during use. The substrate heats up when the light emitting elements are turned on, and this heat radiates when they are turned off. The substrate repeatedly expands and contracts in such a heat cycle, and is consequently susceptible to stress. Warping or deforming of the substrate due to heat may result in cracking of a soldered portion. EP 1 767 967 A2, US 6 552 658 B1 and EP 1 030 099 A2 describe known lighting apparatuses.

A lighting apparatus adopting LEDs as light emitting elements is disclosed in Jap. Pat. KOKAI Applin. No. JP2006-172895A. This lighting apparatus corresponds to the preamble of claim 1 and includes a light translucent lens and a printed board with LEDs mounted thereon. The lens controls the distribution of a luminous flux emitted from the LEDs. This lens accommodates the printed board, and projections extending from the periphery of the lens are fixed to a mounting plate with fastening screws.

The substrate for the lighting apparatus disclosed in Jap. Pat. KOKAI Applin. No. JP2006-172895A is disposed in contact with the mounting plate via a heat conductive sheet, fixture of the substrate is insufficiently secure. In addition, nothing is mentioned about any means for minimizing overall deformation of the substrate.

The present invention provides a lighting apparatus as specified in claim 1 that minimizes deformation of a substrate by ensuring secure mounting of the substrate even when the number of light emitting elements is increased.

Further advantageous embodiments are defined in the dependent claims

In the present invention, the definitions of terms and technical means are as follows unless otherwise specified: the light emitting elements are solid light emitting elements such as LEDs or organic EL. It is preferable that the light emitting elements are mounted by a chip-on-board system or by a surface mounting system. On account of the characteristics of the present invention, the mounting system is not limited in particular. It is not limited the number of light emitting elements to be mounted either. Examples of the main body include a case, cover, and a heat radiation member. Further, a cushioning material that has thermal conductivity or insulating properties may be disposed between the main body and the substrate.

The invention can be more fully understood from the following detailed description when taken in conjunction with the accompanying drawings, in which:
FIG. 1 is a perspective view of a lighting apparatus according to a first embodiment of the present invention;
FIG. 2 is an exploded perspective view of the lighting apparatus shown in FIG. 1;
FIG. 3A is a plan view of the surface of the substrate shown in FIG. 2;
FIG. 3B is a view of a pattern of an electrode for the substrate shown in FIG. 3A;
FIG. 4 is a plan view of a reflector shown in FIG. 2 as viewed from the emission side;
FIG. 5 is a sectional view taken along the line A-A in FIG. 4;
FIG. 6 is a sectional view of the lighting apparatus, showing a state in which the substrate, reflector, and light distributor shown in FIG. 2 are fitted to the main body;
FIG. 7 is a sectional view of a lighting apparatus according to a second embodiment of the present invention, showing a state in which the substrate, reflector, and light distributor are fitted to the main body of the apparatus; and
FIG. 8 is a view of a lighting apparatus according to a third embodiment of the present invention, showing a state in which the substrate is fitted in a mounting area.

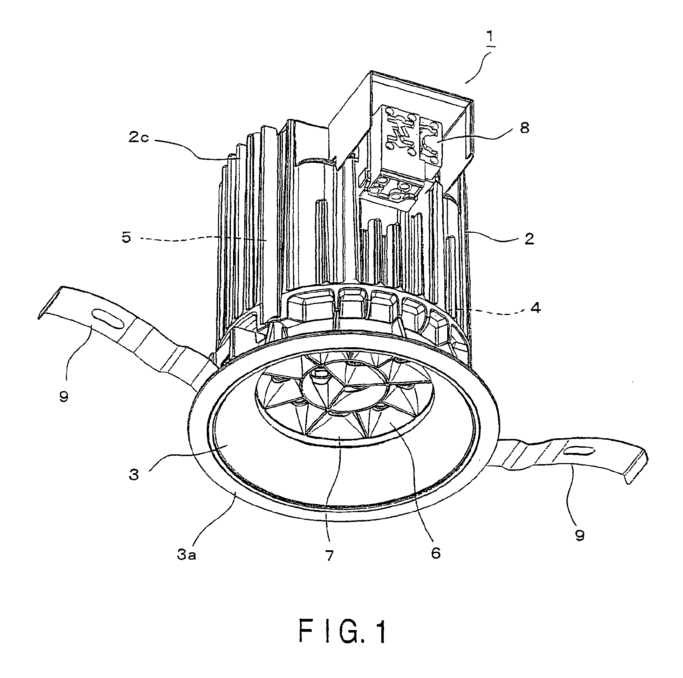

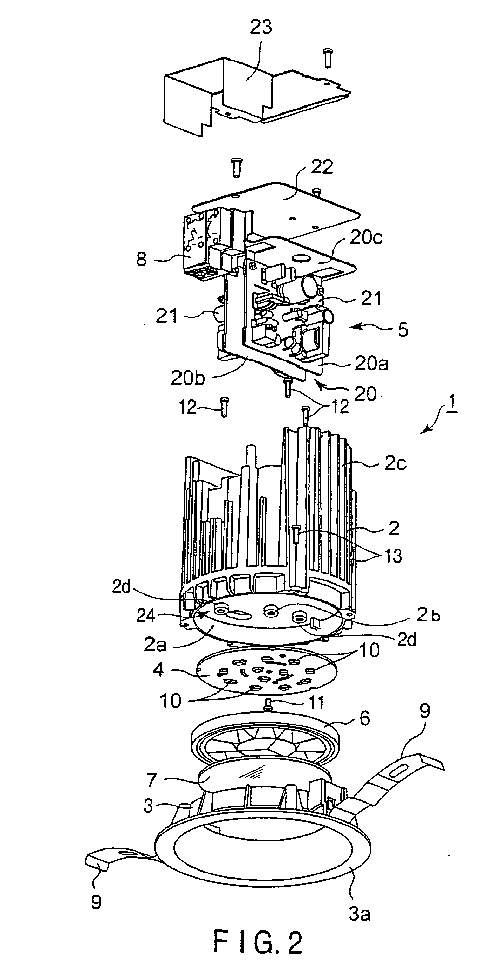

A lighting apparatus according to a first embodiment of the present invention will be described as a down-light 1 that is embedded in a ceiling C, with reference to FIGS. 1 to 6. As shown in FIGS. 1 and 2, the down-light 1 includes a main body 2, a light distributor 3, a substrate 4, a power source unit 5, a reflector 6, and a translucent cover 7. In the present embodiment, "top" and "bottom" are defined according to the position in which the down-light 1 is used. Note also that, in this specification, the direction in which light is emitted may be called "front" or "face" and its opposite direction may be called "rear" or "back".

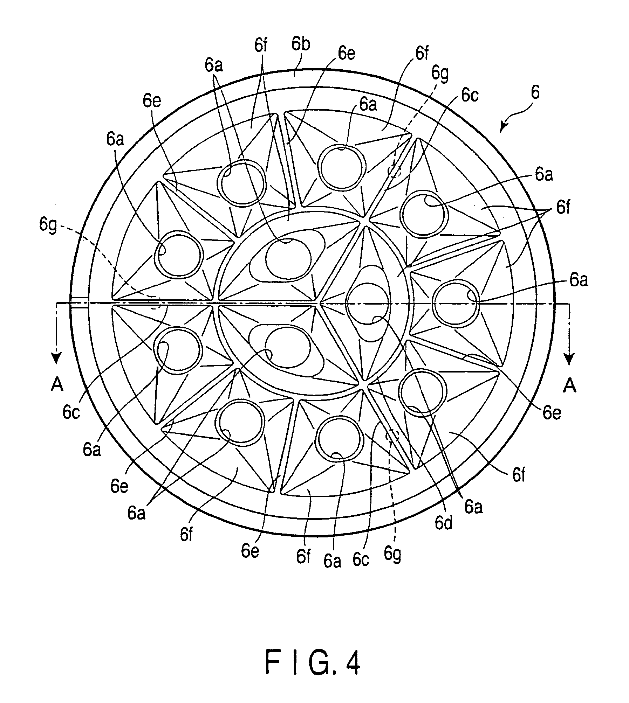

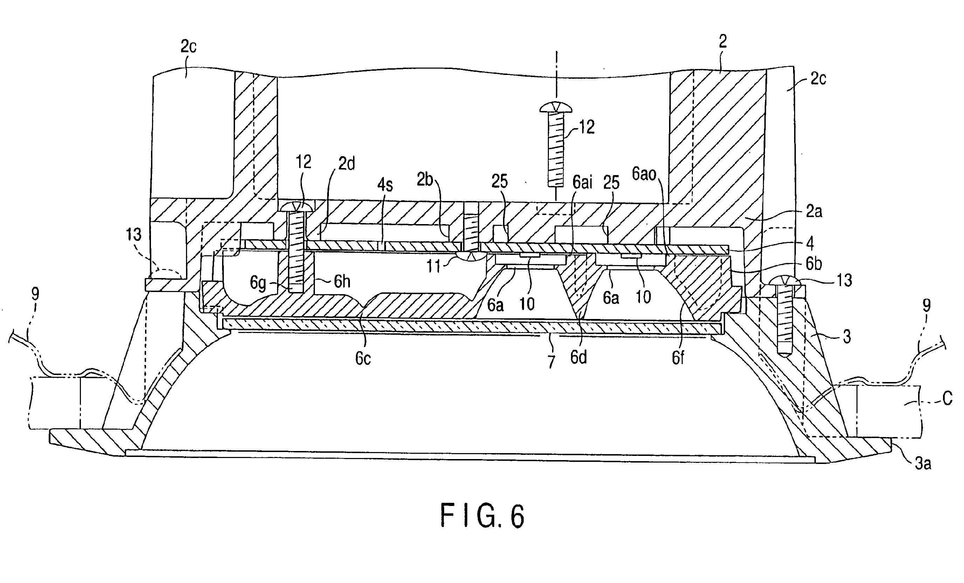

The main body 2 is made of a heat conductive material and has a cylindrical shape with a bottom wall 2a. As shown in FIGS. 2 and 6, a recess for use as a mounting area 24 is formed in the bottom wall 2a. As shown in FIG. 6, the light distributor 3 is mounted along the periphery of the mounting area 24 of the main body 2. As shown in FIGS. 2 and 4, the substrate 4, on which LEDs 10 serving as light emitting elements are mounted, is attached to the mounting area 24 disposed on the main body 2. As shown in FIG. 2, the power source unit 5 includes a circuit module 20 accommodated in the main body 2. As shown in FIGS. 2 and 6, the reflector 6 is attached to the main body 2, with the substrate 4 interposed therebetween. The translucent cover 7 is disposed on the light emitting side of the reflector 6, as shown in FIGS. 2 and 6. The translucent cover 7 may be white, semitransparent, or diffusing. As shown in FIG. 1, the main body 2 has a terminal base 8 on its external face. The light distributor 3 has a pair of leaf springs 9 for fixing the light distributor 3 to a ceiling panel.

The main body 2 is formed by die-casting a highly heat conductive material, for example, aluminum alloy. The external face of the main body 2 is bake-coated with white melamine resin paint. As long as heat conductivity for the main body 2 is ensured, the main body 2 may be made of other material. Additionally, the main body 2 has a plurality of heat radiating fins 2c vertically on its external face. The main body 2 has a central boss 2b projecting at the center of the mounting area 24 provided on the bottom wall 2a, and a plurality of peripheral bosses 2d disposed around the central boss 2b. The heights of the central boss 2b and peripheral bosses 2d are less than the depth of the mounting area 24. The central boss 2b has a screw hole that opens downwards. Each of the peripheral bosses 2d has a through-hole, which is made through the bottom wall 2a. The main body 2 accommodates the power source unit 5.

As shown in FIG. 2, the power source unit 5 includes (1) a circuit module 20 composed of two circuit boards 20a and 20b and (2) a holding plate 20c for mounting the circuit boards 20a and 20b thereon. Mounted on the circuit module 20 are electronic components 21 such as a control IC, transformer, and capacitor. The circuit module 20 is inserted into the main body 2 from above. Thereafter, a cover 22 is placed over the top of the circuit module 20 and fastened to the main body 2 with screws. Thus, the circuit boards 20a and 20b are accommodated and in the main body 2 so as to be completely surrounded.

Further, a top plate 23 is attached to the top of the cover 22. The circuit module 20 controls the turning on and off of the LEDs 10, which are light emitting elements, by a power source circuit configured on the circuit boards 20a and 20b, and is electrically connected to the substrate 4 on which the LEDs 10 are mounted. The power source unit 5 is connected to the terminal base 8, which is connected to a commercial power source.

The light distributor 3 is formed from ABS (Acrylonitrile-Butadiene-Styrene) resin in a beveled shape spreading downwards, as shown in FIG. 2. The light distributor 3 is formed integrally with an annular flange 3a, which formed on the open end extending outward, in order to serve as a decorative frame. The upper end of the light distributor 3 is fixed to the main body 2. A pair of leaf springs 9 is attached to the periphery of the light distributor 3. These leaf springs 9 function as anchors securing the down-light 1 to the panel of the ceiling C, as shown in FIG. 6.

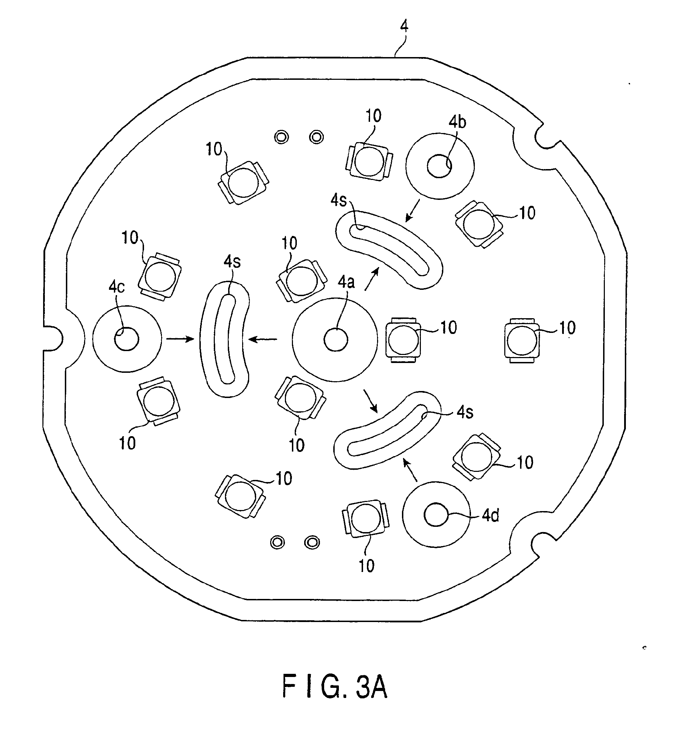

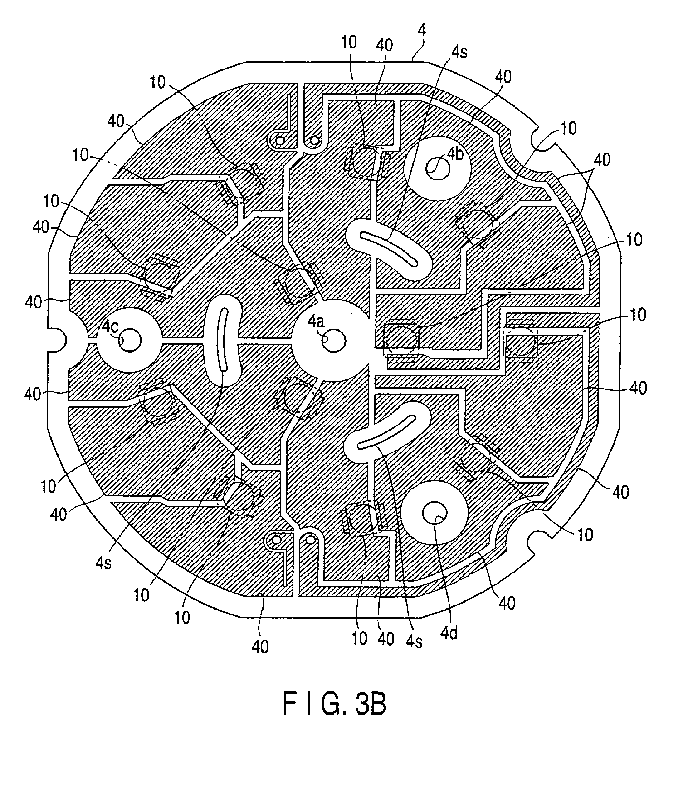

As shown in FIG. 3A, the substrate 4 has a plurality of LEDs 10 for use as light sources. In the present embodiment, three in the central area, and nine on its perimeter, thus twelve LEDs 10 are totally disposed on the surface of the substrate 4 by a surface mounting system. Electrodes 40, to which the LEDs 10 are connected, are formed to cover almost the entire surface of the substrate 4, as shown in FIG. 3B. Each of the electrodes 40 also functions as a heat radiating plate for the corresponding LED 10. Therefore, electrodes are divided into substantially equal areas. The substrate 4 is a flat disk made of an insulating material or metal, and is attached to the main body 2 by means of the central boss 2b and peripheral bosses 2d formed on the mounting area 24 defined on the bottom wall 2a of the main body 2. When an insulating material is used as the material of the substrate 4, a ceramic or synthetic resin material may be used, as long as it has satisfactory heat radiating characteristics and excellent durability. A specific example of such a synthetic resin material is a glass epoxy resin. When a metal is used as the material for the substrate 4, it is preferable to use a material, such as aluminum, which is a satisfactory conductor with excellent radiating of heat.

The entire back face of the substrate 4 is covered with an excellent heat conductive material, such as a copper layer. This copper layer is insulated from the circuit provided for the LEDs 10 mounted on the substrate 4. Heat generated while the LEDs 10 are functioning is diffused over the entire substrate 4 by the copper layer and radiated from the copper layer. The copper layer diffuses, so as to prevent heat from being locally applied to the substrate 4, and thus any heat stress affecting the substrate 4 is evenly spread.

The substrate 4 has a plurality of fixing areas through which central fixing means and peripheral fixing means are passed in order to fix the substrate 4 to the main body 2. The fixing area defined in the center of the substrate 4 in order to attach the central fixing means is a central through-hole 4a. The fixing areas defined on the perimeter of the substrate 4 in order to attach the peripheral fixing means are peripheral through-holes 4b, 4c, and 4d, which are provided three in this embodiment. The peripheral through-holes 4b, 4c, and 4d are made at 120° intervals around the central through-hole 4a.

The substrate 4 has slots 4s in the shape of a gentle arc formed concentrically around the central through-hole 4a between the central through-hole 4a and the peripheral through-holes 4b, 4c, and 4d. These slots 4s are provided as heat expansion absorbing means for absorbing expansion of the substrate 4 caused by heat. Specifically, the slots 4s are formed across corresponding lines connecting the central through-hole 4a and the corresponding peripheral through-holes 4b, 4c, and 4d. Additionally, another slot may be formed across the line connecting the through-holes 4b and 4c, yet another slot across the through-holes 4c and 4d, and yet another slot across the through-holes 4d and 4b.

The substrate 4 is attached to the main body 2 by the central and peripheral fixing means in the central through-hole 4a and peripheral through-holes 4b, 4c, and 4d respectively. The substrate 4 is exposed to a heat cycle in which the substrate 4 absorbs heat while the LEDs 10 are functioning and radiates heat when the LEDs 10 are turned off. Therefore, the substrate 4 repeatedly expands and contracts, and is consequently stressed. At this time, the slots 4s relieve the stress caused by heat expansion acting in the directions indicated by the arrows in FIG. 3A. Since such stress acting on the substrate 4 can be reduced, undesirable warp or deformation is minimized. Incidentally, the substrate 4 is not fixed but free in the radial directions other than the directions extending from the central through-hole 4a towards the peripheral through-holes 4b, 4c, and 4d and, accordingly, the degree of stress acting in those directions is small.

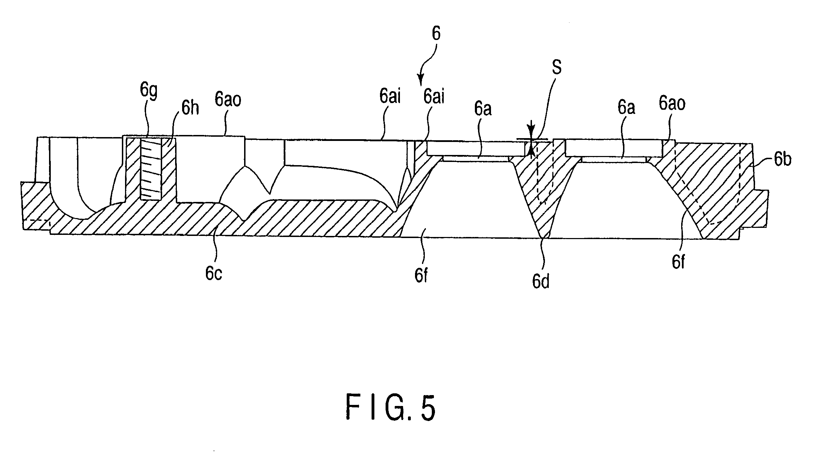

As shown in FIGS. 2 and 6, the reflector 6 is disposed on the face side of the substrate 4, i.e., the side where the LEDs 10 are mounted, and is formed of, for example, white polycarbonate or ASA (Acrylonitrile Styrene Acrylate) resin. The reflector 6 has the function of controlling the distribution of light emitted from the LEDs 10, ensuring that light emission is efficient. As shown in FIGS. 4 and 5, the reflector 6 has the shape of a disk and has light emitting openings 6a positioned to correspond to the LEDs 10 mounted on the substrate 4. As shown in FIG. 6, the reflector 6 has an annular peripheral edge 6d that fits in the mounting area 24 of the main body 2. In addition, as shown in FIG. 4, the light emitting openings 6a are independently separated by radial partitions 6c, an internal circumferential partition 6e, and dividing partitions 6e.

The radial partitions 6c are arranged so as to radiate from the center of the reflector 6 to the outer circumferential edge 6b thereof at approximately 120° intervals and extend between the light emitting openings 6a corresponding to the three LEDs 10 located near the center. The internal partition 6d is formed in the shape of a circle between the center and the outer circumferential edge 6b, in other words, between the light emitting openings 6a corresponding to the three central LEDs 10 and the light emitting openings 6a corresponding to the nine LEDs 10 disposed around those three, so as to divide each of the radial partitions 6c in half. The dividing partitions 6e are provided such that two each partitions 6e are disposed between the outer circumferential edge 6b and the internal circumferential partition 6d, which is located between the radial partitions 6c. That is, two each dividing partitions 6e separate one from another the corresponding three light emitting openings 6a, into which the nine light emitting openings 6a corresponding to the nine LEDs 10 disposed near the outer circumference of the substrate 4 are divided by the radial partitions 6c.

The partitions, which are the radial partitions 6c, internal circumferential partitions 6d and dividing partitions 6e, separating the light emitting openings 6a in the reflector 6 define paraboloids, each of which has a bowl-like shape spreading toward the ridge from the corresponding light emitting opening 6a, as shown in FIG. 5. Each partition facing the substrate 4 is carved as shown in FIG. 5. Each paraboloid defined by the partitions for the corresponding light emitting opening 6a composes a reflecting face 6f. As shown in FIG. 5, the reflector 6 has a stem 6h near the outer circumferential edge 6b of each radial partition 6c that faces the substrate 4. Each stem 6h has one screw hole 6g formed from the substrate 4 side. The stems 6h and screw holes 6g are formed in three areas of the reflector 6, as shown in FIG. 4. Additionally, as shown in FIG. 5, an edge 6ai defining each of the three light emitting openings 6a located inside the internal circumferential partition 6d as shown in FIG. 5 is lower a step S, which is approximately 0.5 mm in leaving direction from the substrate 4, than an edge 6ao defining each of the light emitting openings 6a disposed outside the internal circumferential partition 6d.

A method for attaching the substrate 4 to the mounting area 24 of the main body 2 will be described with reference to FIG. 6. In FIG. 6, the leaf springs 9 are not shown. As shown in FIG. 6, the mounting area 24 provided on the bottom wall 2a of the main body 2 has the central boss 2b located at a part corresponding to the central through-hole 4a in the substrate 4, and has the peripheral bosses 2d located at a part corresponding to the peripheral through-holes 4b, 4c and 4d. In addition, the mounting area 24 has pads 25 arranged on each part corresponding to the LEDs 10. These pads 25 are identical in height to the central boss 2b and peripheral bosses 2d, and abut on the back face of the substrate 4. The pads 25 are continuously formed with the main body 2 which has an excellent heat conductivity. The pads 25 abut on the back of the substrate on which the LEDs 10 are arranged, and thereby absorb heat generated by the LEDs 10.

The stems 6h of the reflector 6 are arranged to face the peripheral through-holes 4b, 4c, and 4d. The back of the reflector 6 facing the substrate 4, in particular, the substrate 4 side outer circumferential edge 6b of the reflector 6, the edges 6ao of the light emitting openings 6a near the outer circumference, and stems 6h abut on the face of the substrate 4 on which the LEDs 10 are mounted.

The substrate 4 and reflector 6 are fixed to the mounting area 24 in the procedure described below. First, the substrate 4 is fitted in the mounting area 24 from below the main body 2. A central screw 11 is passed through the central hole 4a and screwed into the central boss 2b, thereby fixing the central part of the substrate 4 to the main body 2. Subsequently, the perimeter of the substrate 4 is fixed to the main body 2 by means of the three peripheral screws 12. These peripheral screws 12 are passed through the holes of the peripheral bosses 2d and the peripheral holes 4b, 4c, and 4d of the substrate 4 from above the main body 2, and screwed into the screw holes 6g of the stems 6h formed on the back of the radial partitions 6c of the reflector 6. Thus, assembly can be facilitated as the reflector 6 is fixed in position by the peripheral screws 12 and simultaneously the fixing of the substrate 4 is completed, after the substrate 4 is positioned and temporarily fixed to the bottom wall 2a by the central screw 11.

The central screw 11 functions as central fixing means. Instead of the central screw 11, the central fixing means may be, for example, a set of stud bolt extending in the central boss 2b with a nut screwed on the bolt, or else may be a rivet driven into the central boss 2b, as long as the central fixing means is able to secure the substrate 4 to the main body 2. Correspondingly, while the peripheral screws 12 function as peripheral fixing means, instead of the peripheral screws 12, the peripheral fixing means may be, for example, a set of stud bolts extending in the stems 6h of the reflector 6 with nuts screwed on the stud bolts projecting upward beyond the bottom wall 2a through the holes of the peripheral bosses 2d, or else may be rivets driven into the stems 6h of the reflector 6 through the holes of the peripheral bosses 2d and through the peripheral holes 4b, 4c, and 4d of the substrate 4, as long as the peripheral fixing means are able to secure both the perimeter of the substrate 4 and the reflector 6 to the main body 2.

The fastening force of the peripheral screws 12 acts around the central boss 2b in the direction in which the perimeter of the reflector 6 is pulled toward the bottom wall 2a. The substrate 4 is firmly fixed to the bottom wall 2a by the fastening force of the central screw 11 applied to fix the substrate 4 to the central boss 2b together with the fastening force of the peripheral screws 12 applied to pull the reflector 6. In this state, the light emitting openings 6a of the reflector 6 are disposed opposite the corresponding LEDs 10 of the substrate 4. The face of the substrate 4 on which the LEDs 10 are mounted is in close contact with the back of the reflector 6 pressed against the face of the substrate 4. At this time, the edges 6ai of each of the light emitting openings 6a located inside than the edges 6ao are left from the substrate 4 by a step S, or level difference. When the peripheral screws 12 are fastened, the edge 6ao of the rear side of each of the light emitting openings 6a located outside than the edges 6ai are first brought into contact with the face of the substrate 4. This increases the degree of close contact between the face of the substrate 4 and the back of the reflector 6. In addition, since the pads 25 are disposed on the back of the substrate 4 on which the LEDs 10 are disposed, the substrate 4 is sandwiched between the pads 25 on the main body 2 and the edges 6ai and 6ao of the light emitting openings 6a of the reflector 6 when the reflector 6 is fitted.

In the down-light 1 according to the first embodiment, the central boss 2b and peripheral bosses 2d disposed on the mounting area 24 of the bottom wall 2a of the main body 2 define spaces between the substrate 4 and the bottom wall 2a. Therefore, conductive members such as an electronic component may be mounted on the rear side of the substrate 4. In this case also, the substrate 4 is firmly fixed to the main body 2. Disposing conductive members on the rear side of the substrate 4, which is opposite the side on which the LEDs 10 are mounted, allows for sufficient insulating distance from the bottom wall 2a. This obviates the need for an insulating member.

The light distributor 3 is fixed to the main body 2 by means of mounting screws 13. The outside diameter of the flange 3a is larger than that of the embedding hole in the ceiling C. With the down-light 1 set on the ceiling C, the flange 3a is hooked around the edge of the embedding hole from below. The down-light 1 according to the present invention has the translucent cover 7, made of acrylic resin, between the light distributor 3 and the reflector 6. The cover 7 is placed in front of the reflector 6, from which light is emitted.

In the foregoing configuration, a lighting circuit in the circuit module 20 functions when power is supplied to the power source unit 5. The LEDs 10 emit light when power is supplied to the substrate 4. Most of the light emitted from the LEDs 10 is transmitted through the cover 7 and emitted forward. Some of the light is once reflected by reflecting faces 6f of the reflector 6 corresponding to the LEDs 10 and, with its distribution thereby controlled, is subsequently transmitted through the translucent cover 7 and emitted forward. Heat generated by the LEDs 10 is transferred from the back of the substrate 4 to the bottom wall 2a of the main body 2 through the central boss 2b, peripheral bosses 2d, and pads 25. Heat generated by the LEDs 10 also diffuses through the electrodes 40 that are formed so as to cover the face of the substrate 4, as shown in FIG. 3B, and is radiated from the surfaces of the electrodes 40. Heat diffused by the electrodes 40 is transferred from the face of the substrate 4 to the reflector 6 as well through the outer circumferential edge 6b of the reflector 6, the edges 6ao of the light emitting openings 6a near the outer circumference, and the stems 6h. Furthermore, heat diffuses by being transferred to the entire main body 2, and is radiated from its external surface in the process of transfer. In this case, the substrate 4 may be deformed due to repeated expansion and contraction caused by heat generated by the LEDs 10. However, the following measures at least are taken: the substrate 4 is firmly mounted; the back of the reflector 6 is pressed against the surface of the substrate 4; and heat generated by the LEDs 10 is efficiently transferred to the main body 2 via the pads 25. Accordingly, the deformation of the substrate 4 is minimized. Additionally, since the substrate 4 is firmly mounted by the fixing means, mounting strength is maintained if the expansion and contraction are repeated. Furthermore, since stress acting on the substrate 4 due to heat expansion is absorbed by the slots 4s, warp or deformation of the substrate 4 is restrained. Also, in the re-flow process used to manufacture the substrate 4, the slots 4s exhibit the function of minimizing deformation caused by heat expansion.

In the foregoing configuration, a cushioning material may be interposed between the back of the substrate 4 and the central boss 2b and peripheral bosses 2d. Accordingly, even if the fastening force of the mounting screws 12 acts on the substrate 4 excessively, the substrate 4 is prevented from fracturing, cracking, or becoming damaged. Further, forming the cushioning material from a heat conductive material makes it possible to transfer the heat of the substrate 4 to the bottom wall 2a of the main body 2 and hence radiate it efficiently. In the down-light 1, the pads 25 are disposed on the bottom wall 2a corresponding to the rear sides of the LEDs 10, and are contact with the substrate 4. The cushioning material in the form of a paste is interposed between the substrate 4 and the pads 25, thereby thermally improving the degree of adhesion. In such configuration, heat generated by the LEDs 10 is effectively transferred to the main body 2.

The first embodiment described above increases the strength with which the substrate 4 is mounted on the main body 2 and stably maintains the mounted state of the substrate 4. In addition, this embodiment minimizes heat deformation of the substrate 4 and reduces stress on the soldered parts of the substrate 4.

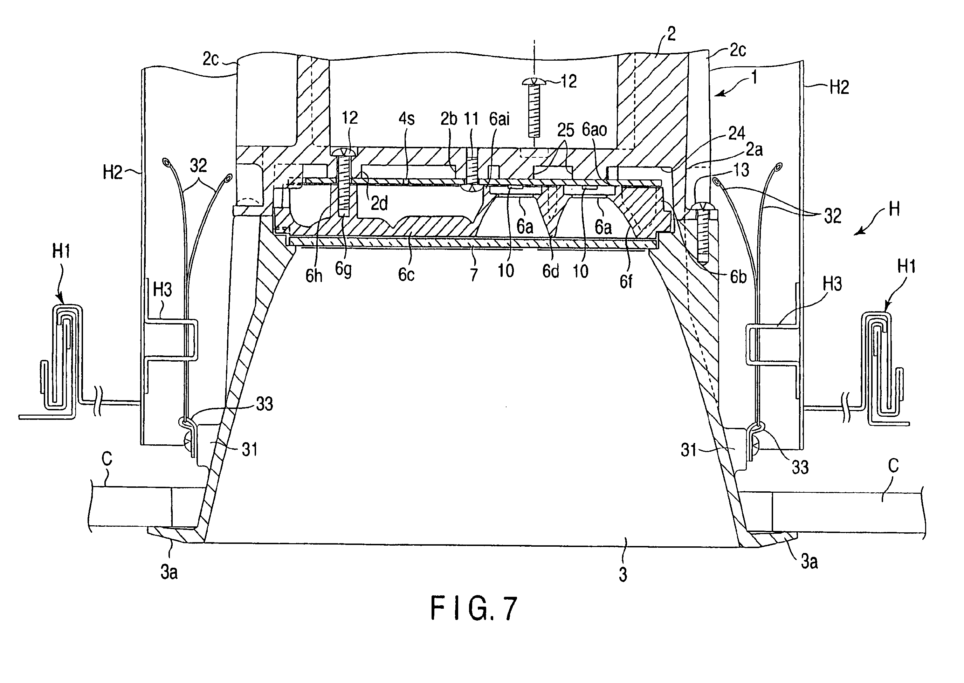

A lighting apparatus according to a second embodiment of the present invention will be described as a down-light 1 with reference to FIG. 7. This down-light 1 is substantially identical to that in the first embodiment and differs from the first embodiment in the method for fixing the down-light 1 to the ceiling C. Therefore, components or the like that have the same function as those of the down-light 1 in the first embodiment are labeled with the same symbols and explanation thereof are omitted.

This down-light 1 is mounted on the ceiling C by means of a housing H. The housing H is fixed to ceiling joists holding the panel of the ceiling C. The housing H has (1) slides H1 disposed between the ceiling joists, and (2) hull H2 attached between the slides H1. The hull H2 has suspending brackets H3 inside.

As shown in FIG. 7, the light distributor 3 of the down-light 1 has a base 31 on its external face and formed wire springs 32. The formed wire springs 32 are connected to the bases 31 by metal parts 33. Each of the formed wire springs 32 is freely spread into a V-shape by its own elasticity, and extends through a hole formed in the suspending brackets H3. The leading ends of the formed wire springs 32 passed through the suspending brackets H3 spread such that a flange 3a is hooked around the panel of the ceiling C, thus fixing the down-light 1 in position.

Since this down-light 1 is fixed to the ceiling C by means of the housing H, the light distributor 3 of the down-light 1 in this embodiment is longer than that in the first embodiment in the direction of light emission. The light distributor 3 is formed by die-casting aluminum alloy having an excellent heat conductive, as in the case of the main body 2. This light distributor 3 is greater than that in the first embodiment in terms of size and hence heat capacity and in the area of heat radiation. The light distributor 3 is attached to the base of the main body 2, thereby absorbing and radiating heat generated by LEDs 10, via the main body 2. It is also preferable that a copper gasket or paste that is excellent heat-conductive be interposed between the main body 2 and light distributor 3, thereby increasing the adhesion area. This down-light 1 has heat releasing capacity which is larger than that in the first embodiment. Accordingly, even when the number of LEDs 10 is increased or the quantity of generated heat increases, heat from the LEDs 10 can still be released.

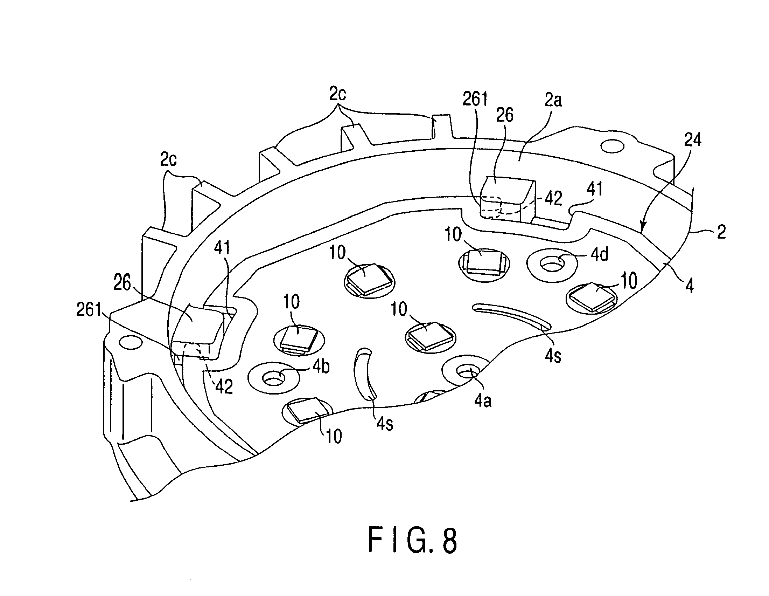

A lighting apparatus according to a third embodiment of the present invention will be described as a down-light 1 as in the first and second embodiments, with reference to FIG. 8. The down-light 1 according to the third embodiment differs from those of the first and second embodiments in the method for mounting a substrate 4 to a mounting area 24 but is identical to those in other configurations. Accordingly, descriptions and drawings corresponding to those in the first and second embodiments are referred to and explanations thereof are omitted.

FIG. 8 shows a state, as viewed from below, in which the substrate 4 is attached to the mounting area 24 formed on a bottom wall 2a of a main body 2. The main body 2 in this embodiment has engagement blocks 26 on a sidewall formed along the internal circumference of the mounting area 24. The engagement blocks 26 have recesses 261 that are open in the direction of the circumference around a central boss 2b. The substrate 4 has notches 41 and pawls 42. Each of the notches 41 is formed by removing part of the substrate 4, and is provided to prevent the engagement blocks 26 from being interfered with the substrate 4 when the substrate 4 is fitted in the mounting area 24. As shown in FIG. 8, each pawl 42 extends in a circumferential direction from the corresponding notch 41 and fits into the recess 261 of the corresponding engagement block 26.

To attach the substrate 4 to the main body 2, the substrate 4 is inserted to the point where it comes into contact with the central boss 2b, peripheral bosses 2d, and pads 25. Then, with the back of the substrate 4 pressed against the central boss 2b, peripheral bosses 2d, and pads 25, the substrate 4 is rotated in the direction which is clockwise in this embodiment, thereby engaging the pawl 42 into the recess 261 of the engagement block 26. The engagement blocks 26 are disposed in three areas substantially in the same direction as those in which the peripheral bosses 2d are disposed around the central boss 2b. The substrate 4 is in firm contact with the central boss 2b, peripheral bosses 2d, and pads 25 when the pawls 42 fits in the recesses 261.

The foregoing configuration simplifies the mounting of the substrate 4 on the main body 2. In addition, it is preferable that a step for supporting the peripheral edge of the substrate 4 be formed along the internal circumference of the mounting area 24. This step has the same height as the central boss 2b, peripheral bosses 2d, and pads 25. Bringing the outer circumferential edge of the substrate 4 into contact with the step when mounting the substrate 4 on the main body 2 allows heat generated by LEDs 10 to release to the main body 2 via this step.

The main body 2 and substrate 4 in such a configuration may be applied in the down-lights in both the first and second embodiments.

Incidentally, the light distributor 3 of the down-light 1 in the first embodiment need not be formed from ABS resin but may be formed by die-casting an aluminum alloy as in the second embodiment. Further, the reflectors 6 in the first to third embodiments may be formed by die-casting aluminum alloy which has excellent heat conductive. A reflector 6 of aluminum alloy allows the active transfer of heat from the LEDs 10 to the reflector 6 by means of the electrodes 40 formed on substantially the entire surface of the substrate 4. Then, heat transferred to the reflector 6 is further transferred to the light distributor 3. Thus, heat generated by the LEDs 10 can be efficiently released.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A lighting apparatus (1) comprising:
a main body (2) with heat conductivity, which has a mounting area (24) formed in a shape of a recess;
a substrate (4) mounted on the mounting area (24);
a plurality of light emitting elements (10) mounted on the substrate (4); and
a reflector (6) mounted on the main body (2) with the substrate (4) interposed therebetween and configured to reflect light emitted from the light emitting elements (10), thereby controlling light distribution,
the lighting apparatus **characterized by** further comprising:
a central boss (2b) formed on the mounting area (24) so as to correspond to a central part of the substrate (4);
central fixing means (11) for fixing the central part of the substrate (4) to the central boss (2b) from the reflector (6) side; and
peripheral fixing means (12) for fixing the substrate (4) to the main body (2) by pulling the reflector (6) from the main body (2) side.

2. The lighting apparatus (1) according to Claim 1, **characterized by** further comprising:
a plurality of peripheral bosses (2d) disposed around the central boss (2b) and supporting a part of the substrate (4) where is provided between its central part and its periphery part,
wherein the peripheral fixing means (12) fixes the substrate (4) to the main body (2) in positions of the peripheral bosses (2d).

3. The lighting apparatus (1) according to Claim 1 or 2, **characterized by** further comprising:
a light distributor (3) mounted along the periphery of the mounting area (24) of the main body (2) so that heat is transferred.

4. The lighting apparatus (1) according to any of Claims 1 to 3, **characterized in that**
the mounting ares (24) has an engagement block (26) on a sidewall formed along an internal circumference of the mounting area (24), the engagement block (26) having a recess (261) in the direction of a circumference around the central boss (2b), and
the substrate (4) has a pawl (42) that fits into the recess (261) of the engagement block (26).

5. The lighting apparatus (1) according to any of Claims 1 to 4, **characterized in that**
the mounting area (24) has a plurality of pads (25) arranged on an area which are corresponding to the light emitting elements (10), and
the pads (25) are contact with the back of the substrate (4).

## Patentansprüche

1. Beleuchtungsvorrichtung (1) mit:
einem Hauptkörper (2) mit Wärmeleitfähigkeit, der einen Montagebereich (24) aufweist, der in Gestalt einer Aussparung geformt ist;
einem Substrat (4), das an dem Montagebereich (24) montiert ist;
einer Vielzahl von lichtemittierenden Elementen (10), die an dem Substrat (4) montiert sind; und
einem Reflektor (6), der an dem Hauptkörper (2) montiert ist, wobei das Substrat (4) dazwischen angeordnet ist und der Reflektor (6) zum Reflektieren von Licht angepasst ist, das von den lichtemittierenden Elementen (10) emittiert wird, um **dadurch** die Lichtverteilung zu steuern,
wobei die Beleuchtungsvorrichtung **dadurch gekennzeichnet ist, dass** sie ferner folgendes enthält:
einen zentralen Vorsprung (2b), der an dem Montagebereich (24) derart geformt ist, dass er einem zentralen Teil des Substrats (4) entspricht;
ein zentrales Befestigungsmittel (11) zum Befestigen des zentralen Teils des Substrats (4) an dem zentralen Vorsprung (2b) von der Seite des Reflektors (6) aus; und
ein dezentrales Befestigungsmittel (12) zum Befestigen des Substrats (4) an dem Hauptkörper (2) durch Ziehen des Reflektors (6) von der Seite des Hauptkörpers (2) aus.

2. Beleuchtungsvorrichtung (1) nach Anspruch 1, **dadurch gekennzeichnet, dass** sie ferner folgendes enthält:
eine Vielzahl von dezentralen Vorsprüngen (2d), die um den zentralen Vorsprung (2b) herum angeordnet sind und einen Teil des Substrats (4) unterstützen, der zwischen dem zentralen Teil des Substrats und dem peripheren Teil des Substrats liegt,
wobei das dezentrale Befestigungsmittel (12) das Substrat an dem Hauptkörper (2) an den Positionen der dezentralen Vorsprünge (2d) befestigt.

3. Beleuchtungsvorrichtung (1) nach Anspruch 1 oder 2, **dadurch gekennzeichnet, dass** sie ferner folgendes enthält:
einen Lichtverteiler (3), der entlang des Umfanges von dem Montagebereich (24) des Hauptkörpers (2) derart befestigt ist, dass Wärme übertragen wird.

4. Beleuchtungsvorrichtung (1) nach einem der Ansprüche 1 bis 3, **dadurch gekennzeichnet,**
**dass** der Montagebereich (24) einen Eingriffsblock (26) an einer Seitenwand aufweist, die entlang eines inneren Umfanges des Montagebereiches (24) geformt ist, wobei der Eingriffsblock (26) eine Aussparung (261) in Richtung eines Umfangs um den zentralen Vorsprung (2b) herum aufweist, und
**dass** das Substrat (4) eine Klinke (42) aufweist, die in die Aussparung (261) des Eingriffsblocks (26) hineinpasst.

5. Beleuchtungsvorrichtung (1) nach einem der Ansprüche 1 bis 4, **dadurch gekennzeichnet,**
**dass** der Montagebereich (24) eine Vielzahl von Pads (25) aufweist, die in Bereichen angeordnet sind, die den lichtemittierenden Elementen (10) entsprechen, und
**dass** die Pads (25) die Rückseite des Substrats (4) kontaktieren.

## Revendications

1. Dispositif d'éclairage (1) comprenant :
un corps principal (2) thermiquement conducteur, qui comporte une zone de montage (24) réalisée en la forme d'un évidement ;
un substrat (4) monté sur la zone de montage (24) ;
une pluralité d'éléments d'émission de lumière (10) montés sur le substrat (4) ; et
un réflecteur (6) monté sur le corps principal (2), le substrat (4) étant interposé entre eux, et configuré pour réfléchir la lumière émise par les éléments d'émission de lumière (10), commandant de ce fait la distribution de lumière,
le dispositif d'éclairage étant **caractérisé en ce qu'**il comprend en outre :
un bossage central (2b) formé sur la zone de montage (24) de manière à correspondre à une partie centrale du substrat (4) ;
des moyens de fixation centrale (11) pour fixer la partie centrale du substrat (4) au bossage central (2b) à partir du côté du réflecteur (6) ; et
des moyens de fixation périphérique (12) pour fixer le substrat (4) au corps principal (2) en tirant le réflecteur (6) à partir du côté du corps principal (2).

2. Dispositif d'éclairage (1) selon la revendication 1, **caractérisé en ce qu'**il comprend en outre :
une pluralité de bossages périphériques (2d) disposés autour du bossage central (2b) et supportant une partie du substrat (4) qui se trouve entre sa partie centrale et sa partie périphérique,
dans lequel les moyens de fixation périphérique (12) fixent le substrat (4) au corps principal (2) aux positions des bossages périphériques (2d).

3. Dispositif d'éclairage (1) selon la revendication 1 ou 2, **caractérisé en ce qu'**il comprend en outre :
un distributeur de lumière (3) monté le long de la périphérie de la zone de montage (24) du corps principal (2) de sorte que la chaleur soit transférée.

4. Dispositif d'éclairage (1) selon l'une quelconque des revendications 1 à 3, **caractérisé en ce que**
la zone de montage (24) comporte un bloc d'engagement (26) sur une paroi latérale formée le long d'une circonférence interne de la zone de montage (24), le bloc d'engagement (26) comportant un évidement (261) dans la direction d'une circonférence autour du bossage central (2b), et
le substrat (4) comporte un cliquet (42) qui s'insère dans l'évidement (261) du bloc d'engagement (26).

5. Dispositif d'éclairage (1) selon l'une quelconque des revendications 1 à 4, **caractérisé en ce que**
la zone de montage (24) comporte une pluralité de pastilles (25) agencées sur une zone et qui correspondent aux éléments d'émission de lumière (10), et
les pastilles (25) sont en contact avec l'arrière du substrat (4).
